# EUROPÄISCHE PATENTANMELDUNG

(11) **EP 4 629 757 A1**
(43) Veröffentlichungstag der Anmeldung: **08.10.2025**
(21) Anmeldenummer: 25163221.2
(22) Anmeldetag: 12.03.2025
(51) Int. Cl.: H05K 3/28, H05K 3/30, H05K 3/36, H05K 1/02, H05K 1/18

(54) **VERFAHREN ZUR HERSTELLUNG EINER LEISTUNGSELEKTRONISCHEN EINRICHTUNG, LEISTUNGSELEKTRONISCHE EINRICHTUNG UND KRAFTFAHRZEUG**

(30) Priorität: 20.03.2024 DE 102024202665
(71) Anmelder: VOLKSWAGEN AG, 38440 Wolfsburg (DE)
(72) Erfinder: Kraft, Silke, 38440 Wolfsburg (DE); Unrau, Arthur, 38440 Wolfsburg (DE); Uhlig, Johannes, 38440 Wolfsburg (DE); Zimmermann, Matthias, 38440 Wolfsburg (DE); Michelsen, Steffen, 38440 Wolfsburg (DE)

(57) **Zusammenfassung**

Die Erfindung betrifft ein Verfahren zur Herstellung einer leistungselektronischen Einrichtung (10), wobei ein Substrat, insbesondere eine Leiterplatte, mit einem Leistungshalbleiter (12) bestückt und ein metallischer Bereich (14) des Substrats mittels einer metallischen Hülse (18) für die Aufnahme eines Steckkontaktes (20) elektrisch kontaktiert wird. Der Leistungshalbleiter (12) und die Hülse (18) werden mit einer Vergussmasse vergossen. Das von dem Substrat wegweisende Ende (28) der Hülse (18) ist während des Vergießens zumindest soweit verschlossen gestaltet, dass ein Eindringen der Vergussmasse verhindert ist.

## Beschreibung

Die Erfindung betrifft ein Verfahren zur Herstellung einer leistungselektronischen Einrichtung, eine nach dem Verfahren hergestellte leistungselektronische Einrichtung sowie ein Kraftfahrzeug mit einer nach dem Verfahren hergestellten leistungselektronischen Einrichtung.

Aus dem Stand der Technik sind Verfahren zur Herstellung leistungselektronischer Einrichtungen bekannt, bei denen ein Substrat, beispielsweise eine Leiterplatte, mit einem Leistungshalbleiter bestückt und ein Bereich des Substrats mittels einer metallischen Hülse für die Aufnahme von Steckkontakten elektrisch kontaktiert werden. Gegenüber anderen aus der Praxis bekannten Verfahren, beispielsweise solchen, bei denen Steckkontakte als Leadframes ausgeführt werden, bietet die Kontaktierung von Bereichen der Leiterplatte mittels einer metallischen Hülse für die Aufnahme eines Steckkontaktes den Vorteil, dass mittels dieser Hülse der Steckkontakt an beliebigen Stellen auf der Leiterplatte positioniert werden kann. Dadurch können beispielsweise Signal- und Steuerkontakte in der Nähe des Leistungshalbleiters in zu der Leiterplatte senkrechter Richtung von der Leiterplatte weg und insbesondere aus der leistungselektronischen Einrichtung herausgeführt werden. Das Herausführen des Kontaktes ist insbesondere dann von Vorteil, wenn die Leistungshalbleiter und die Hülsen mit einer Vergussmasse vergossen werden.

Bei den aus dem Stand der Technik bekannten Modulen besteht jedoch das Risiko, das Vergussmasse in die Hülsen eindringt. Dies wiederum führte dazu, dass die Hülsen mit Vergussmasse aufgefüllt und damit für die Aufnahme eines Steckkontaktes unbrauchbar werden.

Die DE 11 2008 000 229 B4 offenbart eine Leistungshalbleitervorrichtung, bei der zylindrische Verbindungsbereiche auf einem metallischen Schaltungssubstrat angeordnet und durch ein Lötmaterial mit dem Schaltungssubstrat im Wesentlichen rechtwinklig verbunden werden. Das Schaltungssubstrat mit den Leistungshalbleiterelementen und den Verbindungsbereichen wird in einem Werkzeug, das aus einem oberen und einem unteren Formteil besteht, aufgenommen und mit einem Spritzharz eingeschlossen. Dabei wird durch das obere Formteil, das die Verbindungsbereiche verschließt, verhindert, dass das Spritzharz in die Verbindungsbereiche eindringt. Bei einem derartigen Verfahren müssen jedoch die Öffnungen der Verbindungsbereiche einen exakten Abstand zum Substrat und dieses eine exakte Dicke einhalten, damit die oberen Enden der Verbindungsbereiche durch das Werkzeug zuverlässig verschlossen werden können. Andernfalls besteht das Risiko, dass doch Spritzharz in die Verbindungsbereiche eindringt. Das Verfahren ist daher anfällig und stellt hohe Anforderungen an die Toleranzen.

Der Erfindung liegt daher die Aufgabe zugrunde, ein Verfahren zur Herstellung einer leistungselektronischen Einrichtung, eine leistungselektronische Einrichtung und ein Kraftfahrzeug mit einer leistungselektronischen Einrichtung aufzuzeigen, die die Herstellung der leistungselektronischen Einrichtung vereinfachen.

Die Aufgabe wird gelöst durch ein Verfahren zur Herstellung einer leistungselektronischen Einrichtung, eine leistungselektronische Einrichtung und ein Kraftfahrzeug mit einer leistungselektronischen Einrichtung mit den Merkmalen der unabhängigen Ansprüche. Die Merkmale der abhängigen Ansprüche betreffen vorteilhafte Ausführungsformen.

Das Verfahren zur Herstellung der leistungselektronischen Einrichtung sieht vor, dass ein Substrat mit einem Leistungshalbleiter bestückt wird. Bei dem Substrat kann es sich um eine Leiterplatte handeln. Das Substrat kann flächig ausgestaltet sein. Bei dem Substrat handelt es sich insbesondere um ein Substrat, das eine Isolierschicht und auf der Isolierschicht metallische Bereiche aufweist. Die metallischen Bereiche können ein Verdrahtungsmuster ausbilden. Das Substrat kann mit einer Mehrzahl Leistungshalbleiter bestückt werden.

Bei dem Leistungshalbleiter kann es sich insbesondere um einen Leistungsschalter für einen Wechselrichter, insbesondere einen Pulswechselrichter, handeln. Der Leistungshalbleiter kann einen Bipolar-Transistor mit isolierter Gateelektrode (IGBT) und/oder einen Metalloxid-Halbleiterfeldeffekttransistor (MOSFET) aufweisen.

Das Verfahren sieht vor, dass ein metallischer Bereich des Substrats mittels der metallischen Hülse für die Aufnahme eines Steckkontaktes elektrisch kontaktiert wird. Dabei wird die metallische Hülse insbesondere in einem, zumindest im Wesentlichen, rechten Winkel zum Substrat orientiert angeordnet. Unter einer Anordnung in einem rechten Winkel zum Substrat ist in diesem Zusammenhang insbesondere zu verstehen, dass sich die Haupterstreckungsrichtung der Hülse, also insbesondere die Richtung, entlang der ein Steckkontakt in die Hülse eingeführt werden kann, rechtwinklig zu den Haupterstreckungsrichtungen des Substrats orientiert ist.

Die Hülse kann hierbei stoffschlüssig mit dem Substrat verbunden werden. Das Verbinden kann insbesondere über Sintern, Löten, Schweißen, insbesondere Ultraschallschweißen und/oder Laserschweißen, und/oder Kleben erfolgen. Die Hülsen können an ihrem zum Substrat hin weisenden Ende eine zu dem Substrat hin orientierte Kontaktfläche aufweisen, mit der sie mit dem Substrat verbunden werden. Die Fläche kann beispielsweise durch eine Verbreiterung der Hülse an ihrem zu dem Substrat hin weisenden Ende geschaffen sein. Eine derartige Gestaltung ermöglicht es insbesondere, die Hülsen zuverlässig im korrekten Winkel zum Substrat auf diesem zu befestigen.

Der Leistungshalbleiter und die Hülsen werden mit einer Vergussmasse vergossen. Beim Vergießen kann das Substrat in einer geeigneten Form aufgenommen sein. Vergussmassen der in Rede stehenden Art werden auch als Moldmassen bezeichnet. Dabei wird insbesondere ein an das Substrat angrenzender Raumbereich mittels der Vergussmasse ausgegossen, so dass ein Verbund aus Substrat und Vergussmasse entsteht, der zu einer Seite hin durch das Substrat begrenzt wird.

Die Aufgabe wird insbesondere dadurch gelöst, dass während des Vergießens die von dem Substrat weg weisenden Enden der Hülse zumindest soweit verschlossen gestaltet sind, dass ein Eindringen der Vergussmasse verhindert ist. Auf diese Weise wird ein Eindringen der Vergussmasse in die Hülse verhindert, das dazu führen würde, dass die Hülse nicht mehr zur Aufnahme des Steckkontaktes dienen könnte. Aufgrund der Tatsache, dass die Verhinderung des Eindringens der Vergussmasse in die Hülse nunmehr eine Folge der Gestaltung der Hülse selbst ist, kann auf Maßnahmen zum temporären Verschließen der Hülse während des Vergießen verzichtet werden. Umständliche und anfällige Lösungen, wie sie beispielsweise aus dem Stand der Technik in Gestalt des Verschließen der Hülse mit dem Oberteil eines Werkzeuges bekannt sind, können entfallen. Das Verfahren gestaltet sich dadurch wesentlich einfacher und kostengünstiger.

Die Aufgabe wird insbesondere dadurch gelöst, dass die Hülse nach dem Vergießen durch eine Bearbeitung des von der Leiterplatte weg weisenden Endes der Hülse eröffnet wird, um das Eindringen des Steckkontaktes in die Hülse zu ermöglichen. Durch das Eröffnen der Hülse nach dem Vergießen durch eine Bearbeitung des von der Leiterplatte weg weisenden Endes der Hülse wird es insbesondere möglich, eine Hülse zu verwenden, deren von dem Substrat weg weisendes Ende aufgrund der Gestaltung der Hülse selbst zumindest soweit verschlossen ist, dass ein Eindringen der Vergussmasse verhindert ist. Das Eröffnen der Hülsen durch eine Bearbeitung des Endes der Hülse lässt sich nach dem Vergießen vergleichsweise einfach und kostengünstig realisieren, da nur ein kleiner Teil der Hülse, nämlich das vom Substrat weg weisende Ende, von der Bearbeitung betroffen ist. Hierdurch ist eine derartige Bearbeitung weitaus unkomplizierter und effizienter als beispielsweise das Erzeugen einer Bohrung als Aufnahme für einen Steckkontakt der in Rede stehenden Art, da diese für die sichere Aufnahme des Stecckontakts eine entsprechende Tiefe erreichen muss.

Bei der Bearbeitung kann es sich um eine materialabtragende Bearbeitung handeln. Dabei wird insbesondere ein Teil des Materials der Hülse entfernt. Derartige materialabtragende Bearbeitungen stellen eine zuverlässige Methode zum Eröffnen des Endes der jeweiligen Hülse dar. Gleichzeitig kann durch die Entfernung eines gegebenenfalls bei der Herstellung bzw. beim Verschließen der Hülse verformten und dadurch die Hülse verengenden Bereichs nah dem von dem Substrat weg weisenden Ende der Hülse erreicht werden, dass sichergestellt ist, dass die Hülse nach der materialabtragenden Bearbeitung im Bereich ihrer von dem Substrat weg weisenden Öffnung auch tatsächlich die gewünschten Abmessungen, insbesondere einen ausreichenden Durchmesser, aufweist. So kann sichergestellt werden, dass die Steckkontakte auch in die Hülsen eingeführt werden können und nicht etwaige Verformungen im Bereich der Öffnung der Hülse ein Einführen des Steckkontaktes verhindern.

Bei der materialabtragenden Bearbeitung kann es sich um eine spanabhebende und/oder eine Bearbeitung mittels eines Lasers handeln. Bei spanabhebenden Verfahren, wie beispielsweise Bohren und/oder Fräsen, handelt es sich um bewährte Bearbeitungsverfahren, die zuverlässig und gut beherrschbar sind. Eine Bearbeitung mittels eines Lasers hat den Vorteil, dass die mechanischen Kräfte, die während der Bearbeitung auf die Hülse einwirken, gering sind. Dies senkt das Risiko unerwünschte Verformungen der Hülse, insbesondere im Bereich der durch das Eröffnen der Hülse erzeugten Öffnung.

Das Verfahren kann vorsehen, dass im Rahmen der materialabtragenden Bearbeitung der Hülse auch ein Abtrag von Vergussmasse erfolgt. Dies kann beispielsweise sinnvoll sein, um im Hinblick auf eine einfache Werkzeuggestaltung die Hülse vollständig mit der Vergussmasse zu umgießen, um anschließend das Ende der Hülse gemeinsam mit einem Teil der Vergussmasse, beispielsweise durch Fräsen, abzutragen.

Bei der Hülse kann es sich um ein Tiefziehteil handeln. Hülsen der in Rede stehenden Art können mittels eines Tiefziehverfahrens kostengünstig in großer Anzahl hergestellt werden.

Das von der Leiterplatte weg weisende Ende der Hülse kann während des Vergießens vollständig verschlossen gestaltet sein. Insbesondere dann, wenn die Hülse als Tiefziehteil hergestellt ist, bietet sich eine derartige Gestaltung an. Das geschlossene Ende kann insbesondere mittels eines Tiefziehverfahrens leicht realisiert werden. Alternativ können jedoch auch andere Fertigungsverfahren zum Einsatz kommen, um eine Hülse mit einem geschlossenen Ende zu erhalten. Bei einem vollständig verschlossenen Ende der Hülse ist ein Eindringen der Vergussmasse in die Hülse mit höchstmöglicher Sicherheit verhindert.

Alternativ kann das von der Leiterplatte weg weisende Ende der Hülse während des Vergießens nicht vollständig, zumindest jedoch soweit verschlossen gestaltet sein, dass ein Eindringen der Vergussmasse durch eine verbleibende Öffnung verhindert ist. Es hat sich in der Praxis gezeigt, dass sehr kleine Öffnungen von Vergussmassen der in Rede stehenden Art beim Vergießen oftmals nicht passiert werden können. Ein Eindringen der Vergussmasse in die Hülse lässt sich in derartigen Fällen auch dann wirkungsvoll verhindern, wenn das von dem Substrat weg weisende Ende der Hülse nicht vollständig verschlossen ist. Das unvollständige Verschließen des Endes der Hülse kann durch Bördeln des Randes der Hülse an dem von dem Substrat weg weisenden Ende der Hülse erfolgt sein.

Die leistungselektronische Einrichtung ist nach einem Verfahren nach der vorliegenden Beschreibung hergestellt.

Die leistungselektronische Einrichtung kann derart gestaltet sein, dass der mittels der Hülse elektrisch kontaktierte Bereich des Substrats elektrisch mit einem Steuerkontakt und/oder einem Signalkontakt des Leistungshalbleiters verbunden sind. Derartige Steuerkontakte bzw. Signalkontakte sind insbesondere nicht dazu ausgebildet, die elektrische Leistung, mit der der durch die leistungselektronische Einrichtung mit elektrischer Energie versorgte Verbraucher versorgt wird, zu übertragen. Daher werden für die elektrische Kontaktierung der Steuerkontakte bzw. der Signalkontakte von Leistungshalbleitern weitaus geringere Leiterquerschnitte benötigt als für die Übertragung der mittels der leistungselektronischen Einrichtung bereitgestellten Leistung. Das Verfahren eignet sich daher insbesondere für die elektrische Kontaktierung derartiger Steuerkontakte und/oder Signalkontakte von Leistungshalbleitern, da gerade Steckkontakte mit vergleichsweise niedrigen Querschnitten vorteilhaft mittels des beschriebenen Verfahrens realisiert werden können.

Die leistungselektronische Einrichtung kann eine Mehrzahl Steckkontakte aufweisen, die jeweils in einer Hülse aufgenommen sind, wobei das beschriebene Verfahren zur Herstellung der elektronischen Einrichtung bei der Herstellung der elektronischen Einrichtung entsprechend auf eine Mehrzahl Hülsen angewendet worden ist.

Die leistungselektronische Einrichtung kann mittels des Steckkontakts mit einem elektronischen Bauelement verbunden sein.

Bei diesem Bauelement kann es sich insbesondere um eine Leiterplatte handeln, die sich in einer Ebene parallel zu dem Substrat erstreckt. Auf diese Weise kann eine elektronische Schaltung zur Ansteuerung der Leistungshalbleiter nach Art eines Schichtaufbaus räumlich vorteilhaft zu dem vergossenen Leistungshalbleiter angeordnet werden. Darüber hinaus erweist sich insbesondere die rechtwinklig vom Substrat weg weisende Orientierung des Steckkontaktes in diesem Zusammenhang als vorteilhaft. Insbesondere dann, wenn die Leistungselektronische Einrichtung eine Mehrzahl Steckkontakte zur Kontaktierung metallischer Bereiche des Substrats aufweist, kann diese Mehrzahl Steckkontakte, die dann insbesondere parallel zueinander ausgerichtet sind, genutzt werden, um ein auf der von dem Substrat weg weisenden Seite der Vergussmasse angeordnetes elektronisches Bauelement zu kontaktieren.

Die leistungselektronische Einrichtung kann weiterhin eine Flüssigkeitskühlung aufweisen. Diese kann insbesondere an der von der Vergussmasse weg weisenden Seite des Substrats angeordnet sein. Eine derartige Anordnung erlaubt eine effiziente Kühlung der Leistungshalbleiter.

Bei der leistungselektronischen Einrichtung kann es sich um einen Pulswechselrichter für den Betrieb eines elektrischen Antriebs oder einen Bestandteil eines solchen Pulswechselrichters handeln. Bei dem Bestandteil der Pulswechselrichter handelt es sich insbesondere um ein Leistungsmodul, das die Leistungsschalter des Pulswechselrichters beinhaltet. Insbesondere eine als Leistungsmodul ausgestaltete leistungselektronische Einrichtung kann mittels des Steckkontakts bzw. der Mehrzahl Steckkontakte mit einer Steuerelektronik zur Ansteuerung der Leistungsschalter des Pulswechselrichters verbunden sein. Die Steuerelektronik kann eine Leiterplatte umfassen, über die die Steuerelektronik mittels der Steckkontakte elektrisch kontaktiert ist. Die Leiterplatte ist hierbei insbesondere parallel zu dem Substrat angeordnet.

Der Pulswechselrichter kann eine Mehrzahl leistungselektronischer Einrichtungen der beschriebenen Art umfassen. Insbesondere kann es sich um drei leistungselektronische Einrichtungen der beschriebenen Art handeln. Dies kann insbesondere von Vorteil sein, um mittels der leistungselektronischen Einrichtung dreiphasigen Wechselstrom bereitzustellen.

Die Mehrzahl leistungselektronischer Einrichtungen des Pulswechselrichters können mittels einer gemeinsamen Flüssigkeitskühlung gekühlt sein. Zu diesem Zweck können die leistungselektronischen Einrichtungen des Pulswechselrichters mit ihren Substraten insbesondere innerhalb einer gemeinsamen Ebene angeordnet sein. Mittels der Steckkontakte können die einzelnen leistungselektronischen Einrichtungen des Pulswechselrichters insbesondere mit demselben Bauelement, insbesondere einer Leiterplatte, verbunden sein. Die Leiterplatte kann sich insbesondere parallel zu den Substraten der einzelnen leistungselektronischen Einrichtungen erstrecken und/oder eine Steuerungselektronik zur Ansteuerung der Leistungshalbleiter der leistungselektronischen Einrichtungen aufweisen.

Das Kraftfahrzeug weist einen elektrischen Fahrantrieb und eine leistungselektronische Einrichtung bzw. eine leistungselektronische Einrichtung, die nach dem beschriebenen Verfahren hergestellt ist, auf. Insbesondere kann das Kraftfahrzeug einen vorstehend beschriebenen Pulswechselrichter mit einer Mehrzahl leistungselektronischer Einrichtungen aufweisen. Die Leistungselektronische Einrichtung dient hierbei zur Versorgung des elektrischen Fahrantriebs mit elektrischer Energie.

Leistungselektronische Einrichtungen der in Rede stehenden Art lassen sich besonders vorteilhaft in einem Kraftfahrzeug zur Versorgung von dessen Fahrantrieb mit elektrischer Energie einsetzen. Aufgrund der erzielbaren kompakten Bauweise und der gleichzeitigen Eignung für eine wirtschaftliche Serienfertigung sind die beschriebenen leistungselektronischen Einrichtungen bzw. das beschriebene Verfahren zu deren Herstellung prädestiniert dafür, die diesbezüglich hohen Anforderungen aus dem Kraftfahrzeugsektor zu erfüllen.

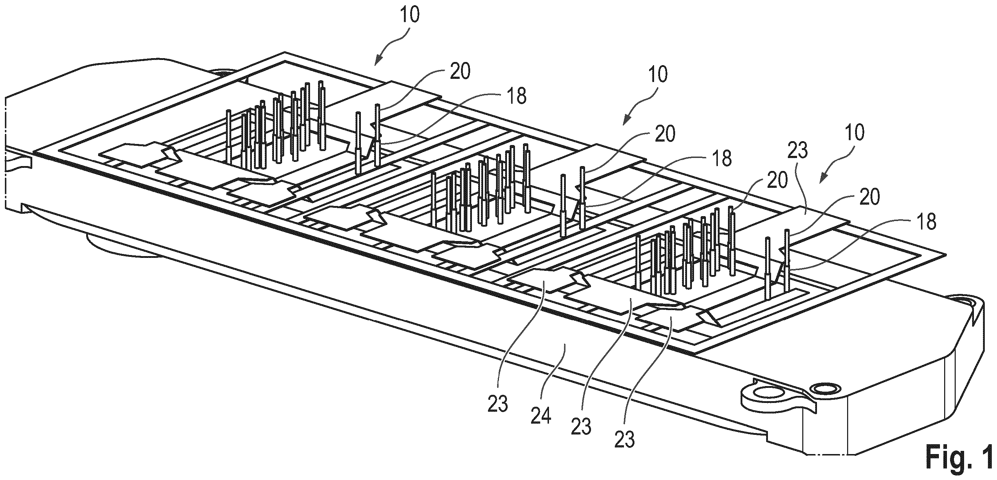

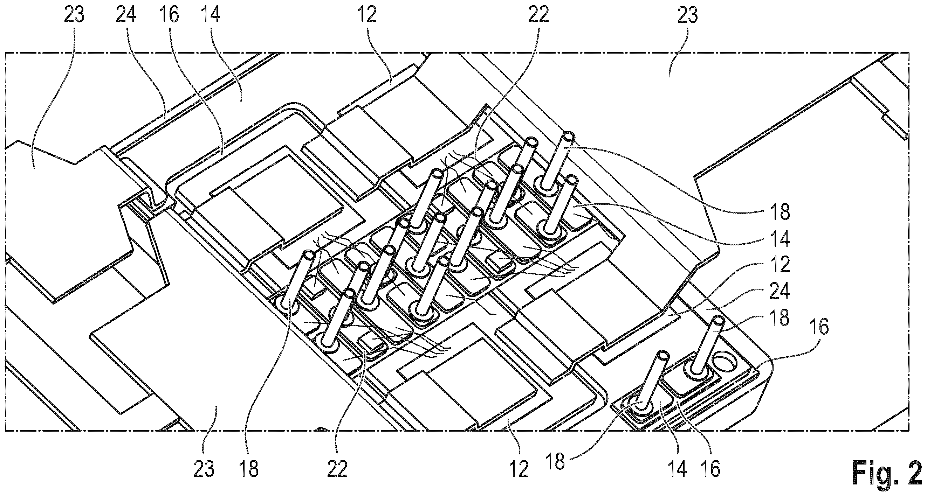

Weitere praktische Ausführungsformen der Erfindung sind nachfolgend im Zusammenhang mit den Zeichnungen beschrieben. Es zeigen:
- Fig. 1: eine schematische Darstellung beispielhafter leistungselektronischer Einrichtungen als Bestandteil eines Pulswechselrichters,
- Fig. 2: eine vergrößerte Darstellung einer der leistungselektronischen Einrichtungen aus Figur 1,
- Fig. 3+4: schematische Darstellungen beispielhafter metallischer Hülsen.
Die beispielhaft dargestellten leistungselektronischen Einrichtungen 10 können wie in den in den Figuren 1 und 2 gezeigten Beispielen Bestandteile eines Pulswechselrichters sein. Im Fall des Ausführungsbeispiels, wie es in der Figur 1 dargestellt ist, weist der Putzwechselrichter drei leistungselektronische Einrichtungen 10 auf. Die einzelnen leistungselektronischen Einrichtungen 10 weisen Leistungshalbleiter 12 auf, die auf einem Substrat angeordnet sind. Das Substrat kann wie im gezeigten Beispiel als Leiterplatte ausgebildet sein und metallische Bereiche 14 aufweisen, die auf einer elektrisch isolierenden Schicht 16 des Substrats angeordnet sind.

Wie in den in den Figuren 1 und 2 gezeigten Beispielen können metallische Bereiche des Substrats mittels metallischer Hülsen 18 elektrisch kontaktiert sein, wobei in den metallischen Hülsen 18 Steckkontakte 20 aufgenommen sind. Wie in dem in Figur 1 gezeigten Beispiel können die Steckkontakte 20 als press-fit-pins ausgeführt sein. In Figur 2 sind die Steckkontakte 20 noch nicht in den metallischen Hülsen 18 aufgenommen.

Die Leistungshalbleiter 12 und die Hülsen 18 sind mit einer Vergussmasse vergossen. Aus darstellungstechnischen Gründen ist die Vergussmasse in den gezeigten Beispielen nicht dargestellt.

Die metallischen Bereiche 14 des Substrats, mit die mit den metallischen Hülsen 18 elektrisch kontaktiert sind, können wie im gezeigten Beispiel durch Drähte 22 mit den Leistungshalbleitern 12 verbunden sein. Eine derartige Kontaktierung bietet sich insbesondere dann an, wenn mittels der in den Hülsen 18 aufgenommenen Steckkontakte 20 Steuereingänge und/oder Signaleingänge der Leistungshalbleiter 12 kontaktiert werden.

Wie in den in Figur 1 gezeigten Beispielen können die leistungselektronischen Einrichtungen 10 mittels weiterer elektrischer Kontakte 23 kontaktiert sein. Diese können insbesondere wesentlich größere Leitungsquerschnitte aufweisen und entsprechend zur Übertragung der durch die Leistungshalbleiter 12 durchgeleiteten elektrischen Leistung dienen.

Weiterhin können wie in den gezeigten Beispielen die leistungselektronischen Einrichtungen 10 mittels einer Flüssigkeitskühlung 24 gekühlt sein. Die Flüssigkeitskühlung 24 kann insbesondere wie dargestellt auf der von den Leistungshalbleitern 12 und den Hülsen 18 abgewandten Seite des Substrats angeordnet sein.

Wie in den gezeigten Beispielen können sich die Hülsen 18 und damit die Steckkontakte 20 rechtwinklig zu dessen Erstreckungsebene vom Substrat weg erstrecken. Eine entsprechende Anordnung, wie sie in den Figuren 1 und 2 zu erkennen ist, erlaubt es, mittels der Steckkontakte 20 eine parallel zu dem Substrat bzw. den Substraten angeordnete Leiterplatte zu kontaktieren. Diese kann insbesondere eine Steuerelektronik zur Ansteuerung der Leistungshalbleiter 12 enthalten, ist in den Figuren 1 und 2 jedoch aus darstellungstechnischen Gründen nicht dargestellt.

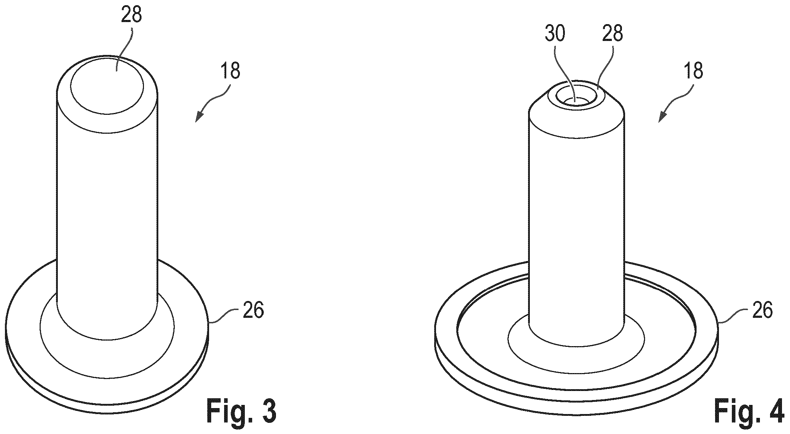

Das Verfahren zur Herstellung der beispielhaft dargestellten leistungselektronischen Einrichtungen 10 sieht vor, dass die von dem Substrat weg weisenden Enden 28 der Hülsen 18 während des Vergießens zumindest soweit verschlossen gestaltet sind, dass ein Eindringen der Vergussmasse verhindert ist. In den Figuren 3 und 4 sind beispielhaft entsprechend gestaltete Hülsen 18 dargestellt. Die Hülsen können wie die beispielhaft dargestellten Hülsen 18 an ihrem zum Substrat hin weisenden Ende eine zu dem Substrat hin weisende Kontaktfläche aufweisen. Diese kann wie im gezeigten Beispiel an der (in den Figuren 3 und 4 nicht sichtbaren) zum Substrat hin weisende Oberfläche einer Verbreiterung 26 der Hülse 18 angeordnet sein.

Wie im Fall der in der Figur 3 dargestellten Hülse 18 kann das vom Substrat weg weisende Ende 28 der Hülse während des Vergießens vollständig verschlossen gestaltet sein. Alternativ kann, wie dies beispielhaft in der Figur 4 dargestellt ist, das von dem Substrat weg weisende Ende 28 der Hülse 18 während des Vergießens nicht vollständig, jedoch soweit verschlossen gestaltet sein, dass ein Eindringen der Vergussmasse durch eine verbleibende Öffnung 30 verhindert ist.

Das Verfahren zur Herstellung einer leistungselektronischen Einrichtung 10 kann vorsehen, dass nach dem Vergießen die Hülse 18 durch eine Bearbeitung des von dem Substrat weg weisenden Endes 28 der Hülse eröffnet wird, um das Einbringen eines Steckkontaktes 20 in die Hülse 18 zu ermöglichen. In der Figur 2 sind die Hülsen 18 in ihrem Zustand nach einem derartigen Eröffnen der jeweiligen Hülse 18 durch eine entsprechende Bearbeitung des von dem Substrat weg weisenden Endes 28 dargestellt. Dabei kann es sich bei der Bearbeitung um eine materialabtragende Bearbeitung handeln, bei der ein Teil des Materials der Hülse 18 entfernt wird um das Innere der jeweiligen Hülse 18 zum Zweck des Einführens des Steckkontakts 20 zu eröffnen.

Die in der vorliegenden Beschreibung, in den Zeichnungen sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung kann im Rahmen der Ansprüche und unter Berücksichtigung der Kenntnisse des zuständigen Fachmanns variiert werden.

### Bezugszeichenliste

- 10: leistungselektronische Einrichtung
- 12: Leistungshalbleiter
- 14: metallischer Bereich
- 16: elektrisch isolierende Schicht
- 18: Hülse
- 20: Steckkontakte
- 22: Draht
- 23: elektrische Kontakte
- 24: Flüssigkeitskühlung
- 26: Verbreiterung
- 28: vom Substrat weg weisendes Ende
- 30: Öffnung

## Patentansprüche

1. Verfahren zur Herstellung einer leistungselektronischen Einrichtung (10), wobei ein Substrat, insbesondere eine Leiterplatte, mit einem Leistungshalbleiter (12) bestückt und ein metallischer Bereich (14) des Substrats mittels einer metallischen Hülse (18) für die Aufnahme eines Steckkontaktes (20) elektrisch kontaktiert wird,
wobei der Leistungshalbleiter (12) und die Hülse (18) mit einer Vergussmasse vergossen werden,
**dadurch gekennzeichnet,**
**dass** das von dem Substrat weg weisende Ende (28) der Hülse (18) während des Vergießens zumindest soweit verschlossen gestaltet ist, dass ein Eindringen der Vergussmasse verhindert ist.

2. Verfahren nach Anspruch 1, **dadurch gekennzeichnet, dass** die Hülse (18) nach dem Vergießen durch eine Bearbeitung des von dem Substrat weg weisenden Endes (28) der Hülse (18) eröffnet wird, um das Einbringen eines Steckkontaktes (20) in die Hülse (18) zu ermöglichen.

3. Verfahren nach Anspruch 1 oder 2, **dadurch gekennzeichnet, dass** es sich bei der Bearbeitung um eine materialabtragende Bearbeitung handelt, bei der ein Teil des Materials der Hülse (18) entfernt wird.

4. Verfahren nach einem der vorigen Ansprüche, **dadurch gekennzeichnet, dass** es sich bei der materialabtragenden Bearbeitung um eine spanabhebende Bearbeitung, insbesondere um Bohren und/oder Fräsen, und/oder um eine Bearbeitung mittels eines Lasers handelt.

5. Verfahren nach einem der vorigen Ansprüche, **dadurch gekennzeichnet, dass** es sich bei der Hülse (18) um ein Tiefziehteil handelt.

6. Verfahren nach einem der vorigen Ansprüche, **dadurch gekennzeichnet, dass** das von der Leiterplatte weg weisende Ende (28) der Hülse (18) während des Vergießens vollständig verschlossen gestaltet ist.

7. Verfahren nach einem der Ansprüche 1 bis 5, **dadurch gekennzeichnet, dass** das von der Leiterplatte weg weisende Ende (28) der Hülse (18) während des Vergießens nicht vollständig, zumindest jedoch soweit verschlossen gestaltet ist, dass ein Eindringen der Vergussmasse durch eine verbleibende Öffnung verhindert ist.

8. Leistungselektronische Einrichtung (10), hergestellt nach einem Verfahren nach einem der vorigen Ansprüche, **dadurch gekennzeichnet, dass** der mittels der Hülse (18) elektrisch kontaktierte Bereiche des Substrats elektrisch mit einem Steuerkontakt (20) und/oder einem Signalkontakt des Leistungshalbleiters (12) verbunden ist.

9. Leistungselektronische Einrichtung (10) nach Anspruch 8 oder hergestellt nach einem der Ansprüche 1 bis 7, **dadurch gekennzeichnet, dass** es sich bei der leistungselektronischen Einrichtung (10) um einen Pulswechselrichter für den Betrieb eines elektrischen Antriebs oder einen Bestandteil eines solchen Pulswechselrichters handelt.

10. Kraftfahrzeug mit einem elektrischen Fahrantrieb und einer leistungselektronischen Einrichtung (10) nach Anspruch 8 oder 9 oder hergestellt nach einem der Ansprüche 1 bis 7 zur Versorgung des elektrischen Fahrantriebs mit elektrischer Energie.
